# EUROPEAN PATENT APPLICATION

(11) **EP 4 734 364 A1**
(43) Date of publication of application: **29.04.2026**
(21) Application number: 25210677.8
(22) Date of filing: 23.10.2025
(51) Int. Cl.: H03F 1/32, H03F 1/34, H03F 3/189, H03F 3/24

(54) **AMPLIFIER DEVICE WITH FEEDBACK AND FEED-FORWARD CONTROL**

(30) Priority: 28.10.2024 NL 2038938
(71) Applicant: Prodrive Technologies Innovation Services B.V., 5692 EM Son en Breugel (NL)
(72) Inventor: SLAATS, Noud, Son en Breugel (NL); VAN ARK, Bart, Son en Breugel (NL)
(74) Representative: Arnold & Siedsma

(57) **Abstract**

An amplifier device (10) comprises a signal input (11) for receiving a reference signal and amplifier circuitry (16). The amplifier device further comprises a feed-forward signal path (135, 145) providing a feed-forward signal. First signal combining circuitry (131, 141) is configured to generate an error signal (I_{ERR}, Q_{ERR}) representative of a difference between the reference signal and a signal proportional to an amplified signal. Signal processing circuitry is configured to process the error signal to obtain a first signal (I_{CRL}, Q_{CRL}). Second signal combining circuitry is configured to combine the first signal and the feed-forward signal to obtain a combine signal which is applied to an input of the amplifier circuitry (16). The signal processing circuitry comprises a limiter (132, 142) coupled to a loop filter (133, 143). The limiter is configured to limit an amplitude of a second signal to a predetermined value thereby obtaining a limited signal. The loop filter is configured to obtain the first signal based on the limited signal.

## Description

### Technical field

The present disclosure is related to amplifier systems, particularly to power amplifier systems such as radio frequency (RF) power amplifier systems utilizing feedback control and feed-forward control.

### Background art

Power amplifiers, such as RF amplifiers, are used in a wide variety of applications including, but not limited to, magnetic resonance imaging (MRI) and semiconductor plasma processing. In these applications, power amplifiers need to have very linear and stable performance in terms of both power and phase. Such specifications cannot be achieved by the power amplifier itself, since a higher efficiency comes at a cost of deteriorated linearity. In MRI applications, generally used Class-AB, B or C amplifiers have reasonable efficiency, but gain compression, memory effects and thermal drift distort the output signal resulting in a deteriorated image quality.

It is known to improve the performance of an amplifier in terms of linearity and stability by implementing a feedback control loop. Different types of control loop methods can be used, such as Cartesian feedback and polar feedback. The Cartesian feedback control has a number of advantages over other feedback control loop methods mainly because bandwidth requirements can be reduced compared to other feedback methods.

One disadvantage of feedback control is that the open-loop gain depends on the gain of the power amplifier. Since an amplifier in higher efficiency modes such as class-AB, B, or C has a significant non-linear behaviour, there is a significant variation in gain when power is varied. As a result, the control loop must be designed that it is stable over the entire range of power and gain. To obtain this effect, the control loop is designed to have lower open-loop gain at low power. Another disadvantage is that when a step variation of power is applied, the open-loop signal path needs to process the full signal level amplitude.

To compensate for these effects, it is known to add feed-forward control and (feed-forward) distortion compensation, also referred to as predistortion. In predistortion, the non-linear behaviour of the amplifier is modelled and a compensation signal is generated. The input to the amplifier is adapted based on the compensation signal to compensate for the non-linear distortion. Hyun H. Boo et al., in Digitally Assisted Feedforward Compensation of Cartesian-Feedback Power-Amplifier Systems, IEEE Transactions on Circuits and Systems - II. Express Briefs, Vol. 58, No. 8, August 2011, disclose that the bandwidth and the in-band linearity of Cartesian-feedback RF power amplifier systems can be enhanced by digitally assisted feed-forward compensation. A feed-forward quadrature predistorted signal is applied in the intermediate frequency path upstream of the quadrature up-converter. The predistorted signal is obtained through a look-up table (LUT), appropriately trained using the control loop.

US 2010/0327932 discloses an amplifier system with Cartesian feedback and feed-forward compensation. The system includes a phase/gain compensator which multiplies a received signal with a complex value to perform phase shift correction and possibly compensating for the gain as well. The phase/gain compensator can be arranged in the main signal path, between reference input and the amplifier, in the feedback path or in the feed-forward path. The complex value can be adaptively determined by a model.

BRAITHWAITE Neil: "Analog Linearization Techniques Suitable for RF Power Amplifiers Used in Integrated Transmitters", 2013 IEEE COMPOUND SEMICONDUCTOR INTEGRATED CIRCUIT SYMPOSIUM (CSICS), 13 October 2013, discloses three types of analog techniques for linearizing RF power amplifiers: feedforward compensation, RF error feedback and analog predistortion. In RF error feedback, an RF error signal ε(t) is phase shifted and amplified by the loop gain β, then fed back to the input of the power amplifier to reduce the power amplifier nonlinearity. A vector modulator is arranged in the open loop path of the power amplifier. The vector modulator is adjusted to cancel the linear component of ε(t), which preserves the linear gain of the system. Braithwaite recommends that a soft limiter be used to bound the magnitude of βε(t). The soft limiter has the effect of reducing the loop gain β, which bounds the magnitude of distortion cancellation. RF error feedback can be combined with analog predistortion (APD), where APD provides the bulk of the distortion cancellation, and RF error feedback can provide 5 dB of incremental cancellation in some parts of the spectrum. RF error feedback can be combined with feedforward compensation, and the oscillatory modes from the feedback are cancelled by the feedforward compensation.

Feed-forward predistortion can counteract the non-linear gain characteristics of the power amplifier, hence resolving the issue of fluctuating open-loop gain and obtaining a consistent total gain and constant loop response. However, there is still a need in the art to further improve transient behaviour of the above systems, particularly for large step responses.

### Summary

It is an object of the present disclosure to provide systems and methods allowing to improve transient behaviour of a power amplifier system, particularly when a large step variation or power pulse is applied. It is an object to improve transient behaviour when power is changed suddenly both from low power to high power and from high power to low power. It is an object to provide such systems and methods which reduce excitation on the circuit components, are easy to implement, have a small footprint and/or provide improved performance.

According to a first aspect of the present disclosure, there is therefore provided an amplifier device, as set out in the appended claims. An amplifier device according to the present disclosure comprises a signal input for receiving a reference signal, a signal output and amplifier circuitry. The amplifier circuitry comprises an amplifier input and an amplifier output, which is coupled to the signal output, e.g. the amplifier output can be the signal output. A main signal path can be defined between the signal input and the signal output and the amplifier circuitry is arranged in the main signal path. The amplifier device further comprises a feed-forward signal path configured to provide a feed-forward signal, e.g. representative of the reference signal. First signal combining circuitry is configured to generate an error signal representative of a difference between the reference signal and a signal proportional to a signal at the amplifier output (feedback signal). The first signal combining circuitry hence can have a first input coupled to the signal input, a second input coupled to the amplifier output, and a first output. The error signal is advantageously provided at the first output and hence applied to the main signal path. The main signal path is hence part of a feedback control loop path, advantageously a Cartesian feedback control loop path. Signal processing circuitry, e.g. arranged in the main signal path, is configured to process the error signal to obtain a first signal. Second signal combining circuitry is configured to combine, e.g. to add, the first signal and the feed-forward signal to obtain a combine signal which is applied to the amplifier input. The second signal combining circuitry hence can have a third input coupled to the first output, a fourth input coupled to the feed-forward signal path and a second output coupled to the amplifier input. The second signal combining circuitry is advantageously configured to provide the combine signal at the second output. The signal processing circuitry can comprise a loop filter configured to process a signal representative of the error signal to obtain the first signal. An output of the loop filter can be coupled to an input of the second signal combining circuitry (i.e., the third input).

According to an aspect of the present disclosure, the signal processing circuitry comprises a limiter, i.e., arranged in the main signal path between the first combining circuitry and the second combining circuitry. The limiter advantageously has an input coupled to the first output (output of the first combining circuitry) and an output coupled to the third input (input of the second combining circuitry). The limiter is configured to limit an amplitude of a second signal of the main signal path (as applied to the input of the limiter) to a predetermined value. Particularly, the limiter is configured to limit the second signal such that it does not exceed the predetermined value at the output of the limiter. The second signal can be the error signal or any other processed signal obtained based on the error signal and hence which is representative of the error signal. Advantageously, the signal processing circuitry is configured to obtain the first signal based on the second signal limited by the limiter. The signal processing circuitry can e.g. be configured to apply filtering to the limited second signal to obtain the first signal and/or any other appropriate signal processing operations, such as applying a (loop) gain to the limited second signal.

The limiter hence is configured to provide for error limitation or error compression. This advantageously makes a significant improvement to step responses of the amplifier output because a large perturbation of the error signal can be prevented. By limiting (clipping or compressing) the error, the transient behaviour and/or settling time can be significantly improved, particularly for large and sudden variations of the input signal. In addition, the limiter allows for reducing voltage stress on the circuit components, increasing service life and reliability.

In some examples, the signal processing circuitry comprises a loop filter which may further be configured to provide a loop gain. Advantageously, the input of the loop filter is coupled to the output of the limiter. The loop filter can hence be configured to process the limited signal (output from the limiter) to obtain the first signal, which is input to the second signal combining circuitry. In addition, the loop filter can be configured to apply a loop gain to the limited signal. In some examples, the loop filter can be configured to apply a frequency-dependent gain to the limited signal. These arrangements enable to reduce excitation of the loop filter and/or loop gain, further making the loop filter and/or loop gain easier to implement.

Advantageous exemplary circuits of the limiter comprise a pair of diodes connected in antiparallel (back-to-back). The back-to-back diodes can be arranged, e.g. in parallel with a resistor, in a feedback path of an operational amplifier, or as a combination of a positively biased clipping diode and a negatively biased clipping diode, both connected to ground. In addition, such examples can further easily combine functions of summing and clipping in a simple circuit that facilitates implementation. Specifically, one of the reference signal and the feedback signal can be 180° phase shifted and both applied to a same input of the limiter circuit that is connected to the back-to-back diodes.

A limiter is particularly suitable in combination with a Cartesian feedback control loop path in which the signal processing circuitry is implemented with parallel in-phase and quadrature signal paths, i.e., signals having a quadrature phase relationship. Separate limiters are advantageously provided for the in-phase and quadrature signal paths and each can operate independently to provide for proper error compression of the respective signal paths without injecting any significant phase shift.

The feed-forward signal path is configured to add a feed-forward signal, advantageously representative of the reference signal, to the signal input to the amplifier circuitry, e.g. to a processed (limited) error signal. Advantageously, the feed-forward signal path adds the reference signal without adaptation, particularly downstream of the limiter. This reduces the amplitude of the error signal that needs to be processed by any signal control circuitry (e.g., loop filter) resulting in improved output performance and reduced transient behaviour.

The amplifier device advantageously comprises signal predistortion circuitry coupled to the amplifier input and configured to generate a predistortion signal for compensating at least in part a non-linearity of a gain of the amplifier circuitry. The predistortion signal can be generated based on the reference signal and the signal predistortion circuitry advantageously has an input coupled to the signal input. The predistortion circuitry allows for linearizing the amplifier output and therefore allows to obtain a coherent response at all power levels.

According to a second aspect, there is provided an apparatus including the amplifier device, as set out in the appended claims. The apparatus can comprise one or more antennas, such as one or more magnetic coils that are driven by the amplifier device of the present disclosure. The amplifier output of the amplifier device is (directly) coupled to an input of the one or more antennas. Advantageously, the one or more antennas are configured to receive a signal output from the amplifier circuitry without further adaptation.

According to a third aspect, there is provided a method of amplifying an electrical signal, as set out in the appended claims. The method is advantageously implemented in the amplifier device of the first aspect.

### Brief description of the drawings

Aspects of the present disclosure will now be described in more detail with reference to the appended drawings, wherein same reference numerals illustrate same features and wherein:
Figure 1 represents a diagram of an amplifier device according to aspects of the present disclosure;
Figure 2 represents a diagram of a clipping circuit that can be implemented as limiter in the amplifier device of Fig. 1;
Figure 3 represents a diagram of an alternative clipping circuit;
Figure 4 represents a diagram of the amplifier device of Fig. 1 in which a predistorter is added;
Figure 5 represents a diagram of an alternative amplifier device with polyphase filter according to aspects of the present disclosure;
Figure 6 represents a diagram of an apparatus including antennas coupled to driving circuits which comprise amplifier devices as described herein;
Figure 7 represents a plot of simulations of the in-phase components of the reference signal, the clipped error signal and the output signal of the loop filter for the amplifier device of Fig. 1;
Figure 8 represents a plot of simulations of a rising edge step response for the amplifier device of Fig. 1 with and without limiter implemented;
Figure 9 represents a plot of simulations of a falling edge step response for the amplifier device of Fig. 1 with and without limiter implemented.

### Detailed description

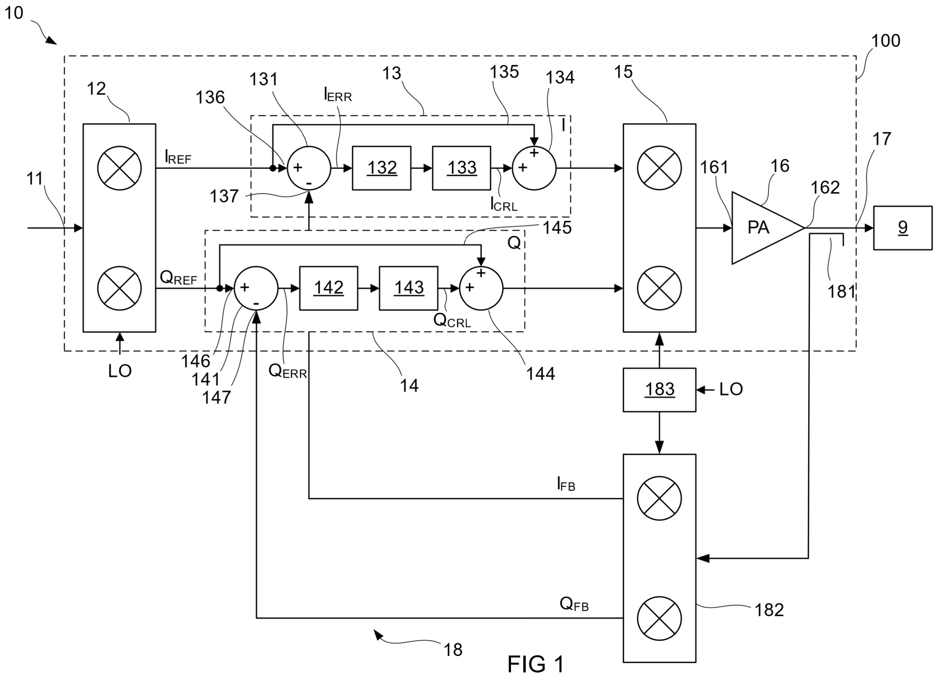

Referring to Fig. 1, an amplifier device or system 10 is configured to increase the energy level of an electrical signal provided at an input 11 of the amplifier system 10 by a factor to obtain an amplified signal and to apply the amplified signal at an output 17. The amplified signal of output 17 is typically utilized to drive a load 9, particularly an antenna, such as a magnetic coil, e.g., of an MRI apparatus, a plasma system or a wireless communications system. The electrical signal can be provided at the input 11 as an analog signal, which can be in a radio frequency (RF) band, an intermediate frequency (IF) band, or which can be a baseband signal. Alternatively, the electrical signal can be provided at input 11 as a digital signal and the amplifier system 10 can comprise a digital to analog converter coupled to input 11 for converting the input signal to the analog domain. The amplified signal at the output 17 is in the analog domain and is typically at radio frequency.

The amplifier system 10 comprises a main signal path 100 from the input 11 to the output 17. A power amplifier (PA) 16, which is basically configured to increase the energy level of (i.e., to amplify) the electrical signal, is arranged in the main signal path. The power amplifier 16 comprises an amplifier input 161 configured to receive an analog signal and an amplifier output 162 coupled to the output 17.

The amplifier system 10 further comprises a feedback control loop, particularly a Cartesian feedback control loop, in which the baseband signal information is processed in Cartesian form, including an in-phase signal path I and a quadrature signal path Q which are arranged in parallel along the main signal path 100. The Cartesian feedback control loop can comprise a signal splitter configured to split the input signal applied at input 11 in quadrature components (i.e., having a quadrature phase relationship) that are processed in individual signal paths I and Q. If the input signal is provided at input 11 at radio frequency, the Cartesian feedback control loop can comprise a frequency down-converter configured to down-convert the (RF) signal frequency to baseband or to an intermediate frequency. Advantageously, a quadrature down-converter 12 combines signal splitting and frequency down-converting operations. If the input signal is provided at input 11 in quadrature components and at baseband or intermediate frequency, e.g., the input signal is a digital signal, the quadrature down-converter 12 can be dispensed with and possibly be replaced with digital to analog converters.

The amplifier system 10 further comprises a quadrature up-converter 15 arranged in the main signal path. Quadrature up-converter 15 has inputs coupled to the I and Q signal paths respectively and has an output coupled to the amplifier input 161. The quadrature up-converter 15 is configured to convert the in-phase and quadrature signals of intermediate or baseband frequency to a combined signal of radio frequency which is input to the power amplifier 16.

Each of the signal paths I and Q comprise individual signal control circuitry 13, 14 respectively, configured to generate and process respective error signals, advantageously in an intermediate frequency band or at baseband. The signal control circuitry 13, 14 are arranged in the open-loop signal path, between the input 11 (quadrature down-converter 12) and the quadrature up-converter 15. The outputs of the signal control circuitry 13, 14 are coupled to the respective inputs of the quadrature up-converter 15.

Each of the signal control circuitry 13, 14 comprises a first summing circuitry 131, 141 respectively, and signal processing circuitry comprising a limiter 132, 142 respectively and advantageously a loop filter 133, 143 respectively. The signal control circuitry 13, 14 further comprises a feed-forward path 135, 145 respectively, coupled to a second summing circuitry 134, 144 respectively. First summing circuitry 131, 141 is configured to generate an error signal I_{ERR}, Q_{ERR}, respectively, from a difference of a reference signal I_{REF}, Q_{REF} received at respective reference inputs 136, 146 coupled to input 11, e.g. as output from quadrature down-converter 12, and a feedback signal I_{FB}, Q_{FB} received at respective feedback inputs 137, 147. First summing circuitry 131, 141 is hence configured to operate as a subtractor.

Feedback input 137, 147 is coupled to a feedback loop 18 for receiving respective quadrature feedback signals I_{FB}, Q_{FB} that are proportional to a signal at output 17. A (directional) coupler 181 is configured to sample the output of the power amplifier 16 and to attenuate it to a suitable level for applying it to a quadrature down-converter 182 which generates I_{FB} and Q_{FB} . A phase shifter 183 is supplied with local oscillator signals LO and configured to generate phase-shifted signals between the quadrature up-converter 15 and the quadrature down-converter 182 to ensure that the up-conversion and down-conversion processes are coherent. The outputs of the quadrature down-converter 182 are coupled to the first summing circuitry 131, 141 of the respective I and Q signal paths at the respective feedback inputs 137, 147. One advantage of the orthogonal nature of the Cartesian feedback system is that the I and Q signal paths can operate completely independently.

Each of the signal control circuitry 13, 14 can comprise a loop filter 133, 143 respectively. Any suitable loop filter can be implemented. The loop filter can be configured to apply a (loop) gain to the error signal and the (loop) gain can be frequency-dependent. The loop filter can have unity gain, such as in a passband frequency range of the loop filter. Alternatively, the loop filter can have a gain different from unity (e.g., smaller than unity, or larger than unity), in the passband frequency range. In some examples, the loop filter comprises a low pass filter. The loop filter can be implemented with an integrating function, such as with a proportional-integral (PI) control model, a proportional-integral-derivative (PID) control model, or an integral control model.

To improve the transient behaviour of large step responses, each of the signal control circuitry 13, 14 comprises a limiter 132, 142 respectively. The limiter 132, 142 has an input coupled to respective summing circuitry 131, 141 and an output coupled to respective loop filter 133, 143. The limiter is configured to limit an (absolute value of the) amplitude of the error signal I_{ERR}, Q_{ERR} of the respective I and Q signal paths such that it does not exceed a predetermined value. More generally, the limiter is configured to reduce the amplitude of an output signal (e.g., as output from the limiter) as a function of the amplitude of an input signal (e.g., as input to the limiter). In some examples, the amplitude of the output signal is reduced only when the amplitude of the input signal exceeds a first predetermined value. The amplitude of the output signal can be reduced such that it does not exceed the first predetermined value, or such that the amplitude of the output signal does not exceed a second predetermined value which may be different from, or equal to, the first predetermined value (e.g. larger for positive amplitudes and smaller for negative amplitudes). Hence the limiter can be configured to attenuate the amplitude of the output signal when the amplitude of the input signal exceeds the first predetermined value. When the amplitude of the input signal does not exceed the first predetermined value, the limiter can be configured to pass the input signal to the output signal without attenuation. In some examples, the limiter can be configured to clip the amplitude of the signal input to it at the first predetermined value, i.e., the limiter can be a clipper circuit. In other examples, the limiter can be configured to compress, e.g., to squash, the amplitude of the signal input to it and thereby preventing the signal output by the limiter from exceeding the first or second predetermined value. The latter operations are also known as soft limiting or soft clipping.

The signal limiting (clipping or compression) provided by the limiter advantageously makes a significant improvement to the transient behaviour of step responses of the amplifier device 10. In addition, a large perturbation of the signal control circuitry 13, 14 of the main signal path 100, and of the loop filter 133, 143 in particular, can be prevented. By limiting the signal in the main signal path, particularly the error signal I_{ERR} Q_{ERR}, the transient behaviour and/or settling time can be significantly improved. It has been found that this is particular true for large steps in input power. When applying a power step input and considering the feedback signal (I_{FB}, Q_{FB}) to be initially zero, the step in the reference signal (I_{REF}, Q_{REF}) will cause the error output from the summing circuitry 131, 141 initially to be equal to the reference signal and therefore very high. This can cause undesired transient behaviour in the amplifier output. The limiter 132, 142 is configured to reduce the amplitude of the error signal in the I and Q signal control paths only for larger input signals, which exceed a predetermined (power) level, whereas for smaller input signals the error signal amplitude is not changed, e.g., passes without attenuation. In addition, the load on the circuit components is reduced, increasing service life and reliability.

In a particular example, the limiter is configured to limit the amplitude of the signal input to it to a threshold level of between 1% and 70%, advantageously between 3% and 50%, advantageously between 5% and 30% of the amplitude of the reference signal at rated peak power of the amplifier device 10 (e.g., the amplitude of the reference signal as applied at the respective reference inputs 136, 146).

The signal control circuitry 13 and 14 can each have an independent limiter 132, 142, i.e., operating independently with respect to each other. These limiters 132 and 142 can be identical to each other, e.g. limiting or reducing the error signal amplitude by same amounts, or they can operate on a different basis. Such operation may induce a small phase shift between the I and Q signals which can be easily absorbed by the other circuit components.

Advantageously, the limiters 132, 142 operate on either one or both positive and negative signal amplitudes, such as to clip either one or both positive and negative signal peaks. The limiters are hence configured to limit the signal amplitude when the amplifier device operates to increase power and/or when the amplifier device operates to reduce power. It will be appreciated that the limiter generally does not rotate the signal, i.e. no phase shift is applied.

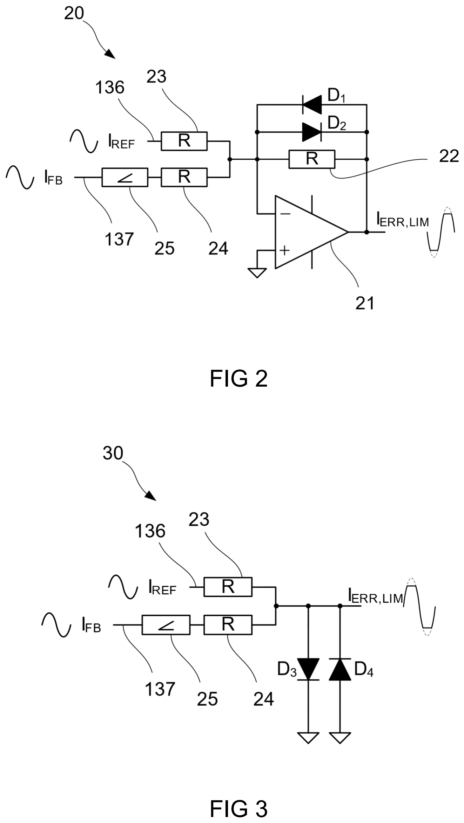

Referring to Fig. 2, one exemplary clipping circuit 20 that can be implemented as combined first summing circuitry 131 and limiter 132, comprises an operational amplifier 21 and a resistor 22 in a feedback path of the operational amplifier 21. A pair of diodes D₁, D₂ are arranged in antiparallel across the resistor 22. The reference input 136 and the feedback input 137 of the first summing circuitry are coupled to the inverting input of the operational amplifier 21 through respective resistors 23, 24 with advantageously equal resistance value R. The non-inverting input of the operational amplifier 21 can be connected to ground. A phase shifter 25 applies a 180° phase shift to the feedback signal I_{FB} at feedback input 137. The clipping circuit 20 will clip the amplitude of the output signal I_{ERR} if the voltage across the feedback resistor 22 increases above the threshold voltage of the diode D₁ or D₂, and both positive and negative peaks can be clipped to obtain a limited error signal I_{ERR,LIM}. By properly choosing the resistor values R of resistors 22 and 23, 24, a clipping voltage can be defined in the in-phase (I) signal path. A same clipping circuit 20 can be provided as combined first summing circuitry 141 and limiter 142 for the quadrature (Q) signal path.

Referring to Fig. 3, another exemplary clipping circuit 30 is arranged as a combinational two-level diode clipper comprising a positively biased clipping diode D₃ and a negatively biased clipping diode D₄ in combination. Both positive and negative peaks can hence be clipped. Instead of a clipping circuit, a compressor circuit can be used as limiter, which is configured to compress or attenuate the signal when it exceeds a predetermined value (e.g., soft clipping), whereas the signal passes unattenuated when it does not exceed the predetermined value.

It will be appreciated that the output of the clipping circuits 20, 30, i.e. the (clipped) error signal I_{ERR}, is applied as input to the corresponding loop filter 133 (or the loop filter 143 for the quadrature error signal).

Referring again to Fig. 1, advantageously, a feed-forward path 135, 145 is respectively provided in the I and Q signal paths. Feed-forward path 135 takes the reference signal I_{REF} at the reference input 136 of the I signal path and adds it to the respective control signal I_{CRL}, e.g. the output of the loop filter 133, in second summing circuitry 134. Feed-forward path 145 takes the reference signal Q_{REF} at the reference input 146 of the Q signal path and adds it to the control signal Q_{CRL}, e.g. the output of the loop filter 143, in second summing circuitry 144. Feed-forward paths 135, 145 advantageously have unity gain. Either one or both can, but need not, comprise a signal attenuator, a signal amplifier or signal filtering circuitry. These feed-forward paths are advantageously added to reduce the signal amplitude which needs to be processed by the first summing circuitry 131, 141 and loop filter 133, 143. The reference signal is therefore advantageously added to the output of the loop filter without attenuation or filtering.

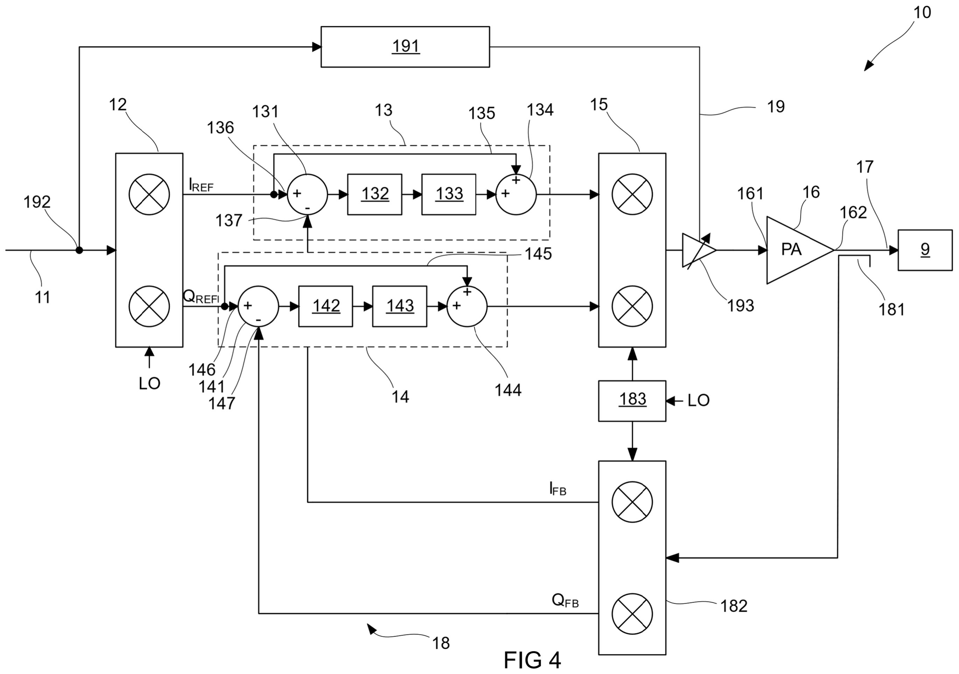

Referring to Fig. 4, the amplifier device 10 can further comprise a predistortion path 19 configured to compensate at least in part the non-linear gain characteristics inherent to the power amplifier (PA) 16. Predistortion path 19 comprises predistortion circuitry 191 configured to generate a predistortion signal based on an input or reference signal applied at the input 11 for at least partially compensating a non-linearity of the power amplifier 16. To this end, the predistortion path can comprise an input 192 coupled to the input 11 of the amplifier device 10. The predistortion path 19 further comprises at its output circuitry, such as a variable gain amplifier 193, configured adapt the signal at the amplifier input 161 based on the predistortion signal. The predistortion signal determines the (tuneable) gain applied by the variable gain amplifier 193 to the signal input to the power amplifier 16, and hence forms a predistortion factor which is configured to compensate at least in part non-linearities of the power amplifier 16. The variable gain amplifier 193 can be replaced by other circuitry configured to adapt a signal based on the predistortion signal, such as a multiplier circuitry or a summing circuitry.

The predistortion circuitry 191 can comprise, or consist of, analog predistortion circuitry, digital predistortion circuitry, or a combination of both. An analog predistortion circuitry can comprise a signal detector, such as a log detector, a linear detector or a mixer, to detect an amplitude of the (analog) signal at input 192 and convert it to a representative voltage. The signal detector is coupled to a scaling circuit which applies a (variable) scaling factor representative of the predistortion to be applied, to obtain the predistortion signal which is applied as a tuneable gain to the variable gain amplifier 193. Optional filtering circuit can be provided to improve transient behaviour.

A digital predistortion circuitry can comprise an analog-to-digital converter (ADC) coupled to the input 192 if an analog signal is applied at the input 11. Digital predistortion circuitry is implemented with distortion compensation logic and is configured to generate a digital predistortion signal that is fed to a digital-to-analog converter for converting the digital predistortion signal to the analog domain for applying it as a tuneable gain to the variable gain amplifier 193. The distortion compensation logic can comprise a look-up table (LUT) or alternatively be implemented with polynomial coefficients for distortion compensation, such as in a micro-processing unit, e.g. an application specific integrated circuit (ASIC) or a field-programmable gate array (FPGA).

The predistortion circuitry 191 advantageously ensures that the total gain from both the variable gain amplifier 193 and the power amplifier 16 remains consistent, regardless of varying power outputs. As a result, it advantageously stabilizes fluctuations in the open-loop gain. This stability in total gain allows for a constant loop response, which can then be adjusted to maintain a consistent output quality across all power levels. Additionally, since it compensates non-linear gain effects of the power amplifier, the predistortion circuitry allows to keep the error signal amplitude in the feedback path relatively small, which advantageously relaxes specifications for the limiter 132, 142 and/or the feed-forward path 135, 145.

It will be appreciated that the input 192 to the predistortion path 19 can be coupled to the I and Q signal paths, i.e. downstream of the quadrature down-converter 12. The predistortion signal may then be applied upstream of the quadrature up-converter 15, resulting in separate predistortion paths for the I and Q signal paths, or alternatively downstream.

It will further be appreciated that the I and Q signal paths, i.e. from respective reference inputs 136, 146 to the quadrature up-converter 15 are advantageously entirely in the analog domain. The limiter 132, 142 is therefore advantageously provided as analog signal processing circuitry.

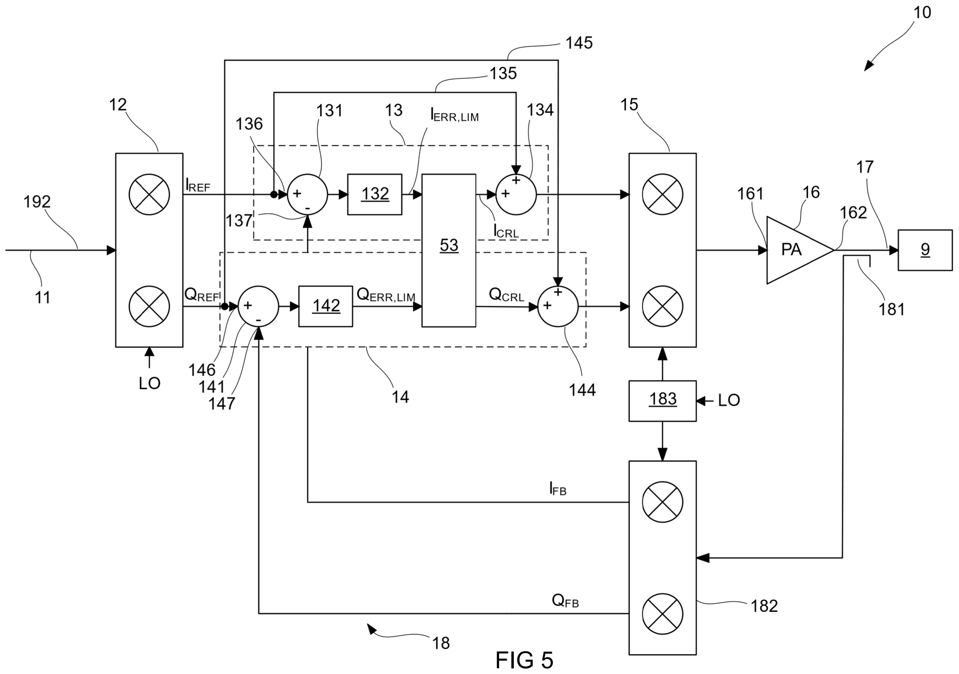

Referring to Fig. 5, in some examples of the amplifier device 10, the loop filters 133, 143 of the signal control circuitry 13, 14 can be replaced with a polyphase filter 53 to obtain cross-coupling between the I and Q signal paths. Polyphase filter 53 receives as inputs, clipped in-phase and quadrature error signals I_{ERR,LIM} and Q_{ERR,LIM} respectively, which are output by limiters 132, 142 respectively. In some examples, the polyphase filter can receive as further inputs, the in-phase and quadrature reference (input) signals, I_{REF} and Q_{REF} respectively (not shown). Polyphase filter 53 is configured to generate in-phase and quadrature control signals I_{CRL} and Q_{CRL} respectively, which are applied to the quadrature upconverter 15. Such a polyphase filter can comprise, or consist of, one or more active polyphase filters as described in US 4723318, which can provide cross-coupling. The polyphase filter can comprise, or consist of a complex band pass error amplifier as described in US 8125270.

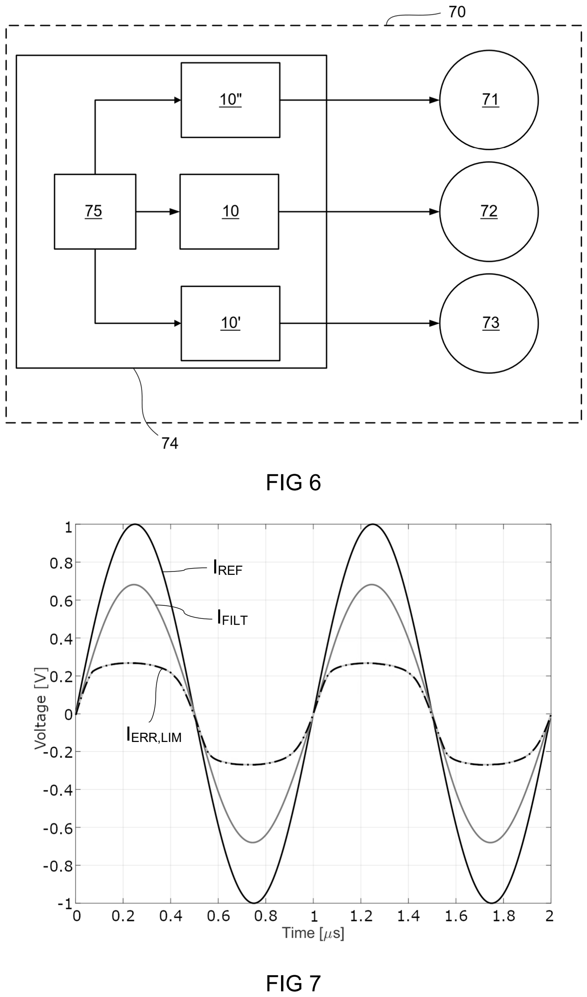

Referring to Fig. 6, an apparatus 70 can comprise one or multiple antennas, such as electromagnetic coils 71, 72, 73, coupled to a driving circuit 74. The driving circuit can comprise a control unit 75 coupled to amplifier devices 10, 10', 10", such as any of the amplifier devices described herein, which are coupled to a respective one of the coils 71-73. The control unit 75 is configured to generate analog or digital driving signals for operating the coils 71-73. These driving signals are fed to the respective amplifier device 10, 10', 10" which generates amplified driving signals for the respective coil. The control unit 75 can be positioned remote from the amplifier device 10, 10', 10" and can be configured to provide analog driving signals as input to the amplifier device 10, 10', 10". The apparatus 70 can be an MRI system in which the coils 71-73 are imaging coils, or a plasma processing system, in which the antennas are coupled to a plasma chamber for generating a plasma within the chamber. The amplified driving signals, output from the amplifier device 10, 10', 10" (output from the PA 16), can be directly applied to the coils 71-73, i.e., without further processing stages such as filtering.

It will be appreciated that while the foregoing examples describe amplifier devices implemented with Cartesian feedback control loops, aspects of the present disclosure can be equally applied to amplifier devices with other types of feedback control, such as polar feedback.

### Simulation results

A simulation was performed on the circuit of Fig. 1. The loop filter had a gain of two. The limiters 132, 142 were implemented as a clipping circuit as in Fig. 2, and the resistors R were selected to obtain positive and negative voltage clipping at about 0.25V. A sine wave of 1V_{PK} was applied as reference signal I_{REF} to the reference input of the I channel. A same wave was input as reference signal to the Q channel, but this is not shown as the result was equal to the I channel result. The feedback signal I_{FB} was grounded. As a result, the error signal is equal to the reference signal. The relevant voltage waveforms are shown in Fig. 7. As can be seen, the output I_{ERR,LIM} of the limiter 132 is clipped at a voltage of approximately 0.25V_{PK}. When fed to the loop filter 133, the higher harmonics of the clipped signal are filtered out, resulting again in a nice smooth sine wave I_{FILT}. Since the gain of the used loop filter was two, the amplitude of the filtered signal is larger, but would be lower if the loop filter had a unity gain configuration.

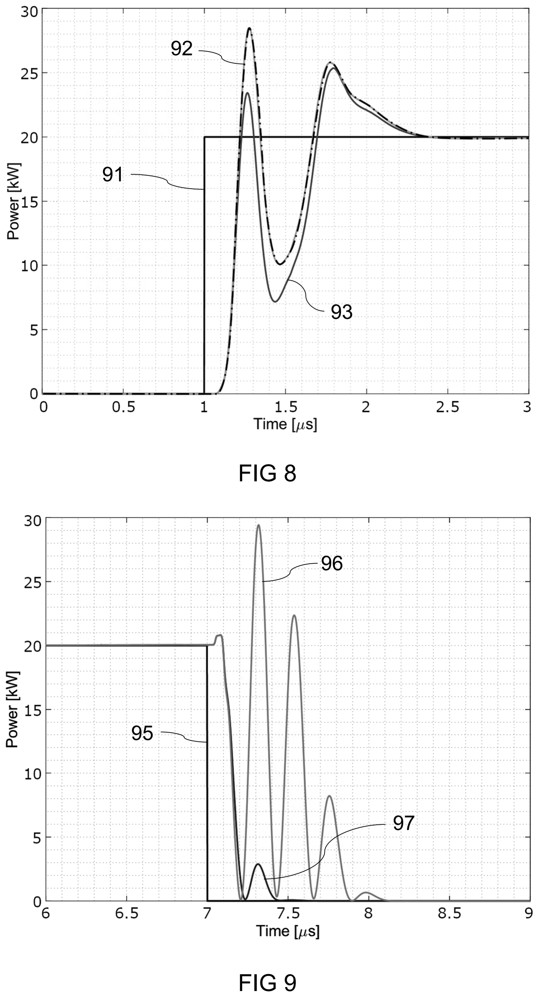

Referring to Fig. 8, a rising edge step 91 from 0 kW to 20 kW was applied as input (reference). The response was simulated for the amplifier device of Fig. 1 with and without limiter. The loop filter had a gain of two. The response (amplifier output) 92, 93 without and with limiter (error clipping according to Fig. 7) respectively, is shown in Fig. 8. It can be seen that the response 93 with error signal clipping has a reduced overshoot. This hence reduces voltage stress on the system components.

Referring to Fig. 9, a falling edge step 95 from 20 kW to 0 kW was applied as input (reference). The response was simulated for the amplifier device of Fig. 1 with and without limiter. Fig. 9 shows the response (amplifier output) 96, 97 without and with limiter (error clipping according to Fig. 7) respectively. It can be seen that the response 96 without error signal clipping (without limiter) gives rise to a significant ringing with peak up to 30 kW which takes more than 1 µs. This is thought to be caused by the non-linear behaviour of the power amplifier. The response 97 with signal clipping has a single ringing "lobe" with peak reduced to 3kW compared to 30 kW if no limiter is used. The response settling time is 0.4 µs, significantly shorter as well.

Aspects of the present disclosure are set out in the following alphanumerically ordered clauses.
**A1.** An amplifier device (10), comprising:
   a signal input (11),
   amplifier circuitry (16) comprising an amplifier input (161) and an amplifier output (162),
   a feed-forward signal path (135, 145, 235),
   first signal combining circuitry (131, 141) configured to generate an error signal (I_{ERR}, Q_{ERR}) representative of a difference between a reference signal (I_{REF}, Q_{REF}) received at the signal input (11) and a signal (I_{FB}, Q_{FB}) proportional to a signal at the amplifier output (162),
   signal processing circuitry (133, 143) configured to process the error signal to obtain a first signal (I_{CRL}, Q_{CRL}),
   second signal combining circuitry (134, 144, 234) configured to combine the first signal (I_{CRL}, Q_{CRL}) and a signal of the feed-forward signal path to obtain a combine signal at an output of the second signal combining circuitry coupled to the amplifier input (161),
   characterised in that the signal processing circuitry comprises a limiter (132, 142, 62) configured to limit an amplitude of a second signal to a predetermined value thereby obtaining a limited second signal (I_{ERR,LIM}), and in that the signal processing circuitry is configured to obtain the first signal based on the limited second signal.
**A2.** Amplifier device of clause A1, wherein the limiter (132, 142, 62) is configured to limit both a positive and a negative amplitude of the second signal.
**A3.** Amplifier device of clause A1 or A2, wherein the predetermined value is between 1% and 70% of a peak amplitude of the reference signal at maximum rated power, preferably between 5% and 50% of the peak amplitude.
**A4.** Amplifier device of any one of the clauses A1 - A3, wherein the second signal is the error signal (I_{ERR}, Q_{ERR}) or a signal representative of the error signal.
**A5**. Amplifier device of any one of the clauses A1 - A4, wherein the signal processing circuitry further comprises a loop filter (133, 143, 53) configured to process a signal representative of the error signal (I_{ERR}, Q_{ERR}) to obtain the first signal.
**A6.** Amplifier device of clause A5, wherein an output of the limiter (132, 142) is coupled to an input of the loop filter (133, 143).
**A7.** Amplifier device of any one of the clauses A1 - A6, wherein the limiter (132, 142, 62) comprises a clipping circuit (20, 30).
**A8**. Amplifier device of any one of the clauses A1 - A7, comprising a Cartesian feedback control loop path, wherein the signal processing circuitry comprises parallel first and second signal paths (I, Q) configured to process signals having a quadrature phase relationship.
**A9.** Amplifier device of clause A8, wherein each of the first and second signal paths comprises the limiter (132, 142).
**A10.** Amplifier device of clause A8 or A9, wherein each of the first and second signal paths (I, Q) comprises individual ones of the first and second signal combining circuitry and of the feed-forward signal path (135, 145).
**A11.** Amplifier device of any one of the clauses A1 - A10, wherein the feed-forward signal path (135, 145, 235) has an input coupled to an input (136, 146) of the first signal combining circuitry (131, 141).
**A12.** Amplifier device of any one of the clauses A1 - A11, further comprising signal predistortion circuitry (191) coupled to the amplifier input (161) and configured to compensate at least in part a non-linearity of a gain of the amplifier circuitry. **A13.** Amplifier device of any one of the clauses A1 - A12, configured to output an analog signal of radio frequency at the amplifier output (162).
**A14.** Amplifier device of any one of the clauses A1 - A13, configured to receive at the signal input (11) an analog signal.
**A15.** Amplifier device of any one of the clauses A1 - A14, wherein the signal processing circuitry (133, 143) consists of analog circuitry.
**A16.** Amplifier device of any one of the clauses A1 - A15, wherein the limiter comprises a pair of diodes (D₁, D₂, D₃, D₄) connected in antiparallel and configured to limit both a positive and a negative amplitude of the second signal.
**A17.** Amplifier device of clause A16, wherein the limiter further comprises an operational amplifier (21) and the pair of diodes (D₁, D₂) are connected in a feedback path of the operational amplifier.
**A18.** Amplifier device of clause A16, wherein the pair of diodes (D₃, D₄) are connected to ground and configured as a combination of a positively biased clipping diode and a negatively biased clipping diode.
**A19.** Amplifier device of any one of the clauses A16 - A18, wherein the first signal combining circuitry and the limiter are combined into a circuit (20, 30) comprising a phase shifter configured to apply a 180° phase shift to one of the reference signal and the signal (I_{FB}, Q_{FB}) proportional to the signal at the amplifier output (162), wherein an output of the phase shifter and the other one of the reference signal and the signal (I_{FB}, Q_{FB}) proportional to the signal at the amplifier output are coupled to the pair of diodes.
**B1.** Apparatus (70), comprising an antenna (71, 72, 73), particularly an electromagnetic coil, and driving circuitry (74) coupled to the antenna and configured to generate a magnetic field by the antenna, wherein the driving circuitry comprises the amplifier device (10) of any one of the clauses A1 - A19.
**B2.** Apparatus of clause B1, wherein the antenna is a magnetic resonance imaging coil.
**C1.** Method of amplifying an electrical signal, the method comprising:
   generating, for a reference signal (I_{REF}, Q_{REF}) to be amplified, an error signal (I_{ERR}, Q_{ERR}) representative of a difference between the reference signal and a signal (I_{FB},Q_{FB}) proportional to an output signal output by an amplifier (16),
   processing the error signal to obtain a first signal (I_{CRL}, Q_{CRL}),
   combining the first signal with a feed-forward signal representative of the reference signal to obtain a combine signal and applying the combine signal to the amplifier to obtain the output signal,
   characterised in that processing the error signal comprises limiting an amplitude of a second signal to a predetermined value to obtain a limited signal (I_{ERR,LIM}), wherein the first signal is obtained based on the limited signal.
**C2.** Method of clause C1, wherein the predetermined value is between 1% and 70% of a peak amplitude of the reference signal at maximum rated power of the amplifier, preferably between 5% and 50% of the peak amplitude.
**C3.** Method of clause C1 or C2, wherein generating the error signal comprises generating quadrature components of the error signal (I_{REF}, Q_{REF}) having a quadrature phase relationship, preferably wherein limiting the amplitude of the second signal comprises limiting an amplitude of each of the quadrature components of the second signal.
**C4.** Method of any one of the clauses C1 - C3, wherein the second signal is the error signal (I_{ERR}, Q_{ERR}), preferably further comprising processing the limited signal by a loop filter to obtain the first signal.
**C5.** Method of any one of the clauses C1 - C4, wherein the output signal is of radio frequency.

## Claims

1. An amplifier device (10), comprising:
a signal input (11),
amplifier circuitry (16) comprising an amplifier input (161) and an amplifier output (162),
a feed-forward signal path (135, 145, 235),
first signal combining circuitry (131, 141) configured to generate an error signal (I_{ERR}, Q_{ERR}) representative of a difference between a reference signal (I_{REF}, Q_{REF}) received at the signal input (11) and a signal (I_{FB}, Q_{FB}) proportional to a signal at the amplifier output (162),
signal processing circuitry (133, 143) configured to process the error signal to obtain a first signal (I_{CRL}, Q_{CRL}),
second signal combining circuitry (134, 144, 234) configured to combine the first signal (I_{CRL}, Q_{CRL}) and a signal of the feed-forward signal path to obtain a combine signal at an output of the second signal combining circuitry coupled to the amplifier input (161),
**characterised in that** the signal processing circuitry comprises a limiter (132, 142) and a loop filter (133, 143, 53),
wherein the limiter is configured to limit an amplitude of a second signal to a predetermined value thereby obtaining a limited signal (I_{ERR,LIM}), wherein the second signal is the error signal or a signal representative of the error signal, and
wherein an output of the limiter (132, 142) is coupled to an input of the loop filter, wherein the loop filter is configured to process the limited signal (I_{ERR}, Q_{ERR}) to obtain the first signal.

2. Amplifier device of claim 1, wherein the limiter (132, 142) is configured to limit both a positive and a negative amplitude of the second signal.

3. Amplifier device of claim 1 or 2, wherein the predetermined value is between 1% and 70% of a peak amplitude of the reference signal at maximum rated power, preferably between 5% and 50% of the peak amplitude.

4. Amplifier device of any one of the preceding claims, wherein the limiter (132, 142, 62) comprises a clipping circuit (20, 30).

5. Amplifier device of any one of the preceding claims, wherein the loop filter (133, 143, 53) is configured to apply a gain to the limited signal.

6. Amplifier device of any one of the preceding claims, comprising a Cartesian feedback control loop path, wherein the signal processing circuitry comprises parallel first and second signal paths (I, Q) configured to process signals having a quadrature phase relationship, preferably wherein each of the first and second signal paths comprises the limiter (132, 142).

7. Amplifier device of claim 6, wherein each of the first and second signal paths (I, Q) comprises individual ones of the first and second signal combining circuitry and of the feed-forward signal path (135, 145).

8. Amplifier device of any one of the preceding claims, wherein the feed-forward signal path (135, 145, 235) has an input coupled to an input (136, 146) of the first signal combining circuitry (131, 141).

9. Amplifier device of any one of the preceding claims, further comprising signal predistortion circuitry (191) coupled to the amplifier input (161) and configured to generate a predistortion signal based on the reference signal (I_{REF}, Q_{REF}) received at the signal input (11) for compensating at least in part a non-linearity of a gain of the amplifier circuitry.

10. Amplifier device of any one of the preceding claims, configured to output an analog signal of radio frequency at the amplifier output (162) and/or configured to receive at the signal input (11) an analog signal.

11. Amplifier device of any one of the preceding claims, wherein the signal processing circuitry (133, 143) consists of analog circuitry.

12. Apparatus (70), comprising an antenna (71, 72, 73) and driving circuitry (74) coupled to the antenna and configured to generate a magnetic field by the antenna, wherein the driving circuitry comprises the amplifier device (10) of any one of the preceding claims, preferably wherein the antenna is an electromagnetic coil, more preferably the antenna is a magnetic resonance imaging coil.

13. Method of amplifying an electrical signal, the method comprising:
generating, for a reference signal (I_{REF}, Q_{REF}) to be amplified, an error signal (I_{ERR}, Q_{ERR}) representative of a difference between the reference signal and a signal (I_{FB},Q_{FB}) proportional to an output signal output by an amplifier (16),
processing the error signal to obtain a first signal (I_{CRL}, Q_{CRL}),
combining the first signal with a feed-forward signal representative of the reference signal to obtain a combine signal and applying the combine signal to the amplifier to obtain the output signal, preferably wherein the output signal is of radio frequency,
**characterised in that** processing the error signal comprises limiting an amplitude of a second signal to a predetermined value to obtain a limited signal (I_{ERR,LIM}) and processing the limited signal by a loop filter to obtain the first signal, wherein the second signal is the error signal or a signal representative of the error signal.

14. Method of the preceding claim, wherein the predetermined value is between 1% and 70% of a peak amplitude of the reference signal at maximum rated power of the amplifier, preferably between 5% and 50% of the peak amplitude.

15. Method of claim 13 or 14, wherein generating the error signal comprises generating quadrature components of the error signal (I_{REF}, Q_{REF}) having a quadrature phase relationship, preferably wherein limiting the amplitude of the second signal comprises limiting an amplitude of each of the quadrature components of the second signal.
